# EUROPEAN PATENT APPLICATION

(11) **EP 4 467 252 A1**
(43) Date of publication of application: **27.11.2024**
(21) Application number: 22921251.9
(22) Date of filing: 16.02.2022
(51) Int. Cl.: B08B 3/04, B08B 3/08, B08B 3/10, H01L 21/02

(54) **EPITAXIAL WAFER RESISTANCE VALUE MEASUREMENT PRETREATMENT METHOD**

(30) Priority: 19.01.2022 CN 202210061622
(71) Applicant: Wafer Works Epitaxial Corp., Qingpu Shanghai 201707 (CN)
(72) Inventor: WU, Yong, Shanghai 201707 (CN); ZHANG, Xiaoyan, Shanghai 201707 (CN); GU, Guangan, Shanghai 201707 (CN)
(74) Representative: Cabinet Chaillot
(86) International application number: PCT/CN2022/076526
(87) International publication number: WO 2023/137815

(57) **Abstract**

The invention relates to a method for processing an epitaxial wafer before measuring its resistance value, comprising the steps of:(1) washing; (2) spin-drying; (3) heating and drying; (4) eliminating static electricity on the wafer. In the method for processing an epitaxial wafer before measuring its resistance value as disclosed in the present invention, the overflow groove process is changed to an overflow + quick discharge process, so as to ensure that the acid and alkali residues on a surface of the wafer are washed out, so as not to affect the measurement effect. Static electricity elimination treatment is used to eliminate static electricity and dangling bonds on the surface of the wafer, so that measurements of the resistance value may not be affected, to a large extent. The resistance uniformity of the epitaxial wafer processed by the method for processing an epitaxial wafer before measuring its resistance value is less than 1.5%, which fully meets the requirements when compared to the industry requirement of less than 3%.

## Description

### BACKGROUND OF THE INVENTION

### 1. Field of the Invention

The invention relates to a method for processing an epitaxial wafer before measuring its resistance value.

### 2. Description of the Related Art

It is necessary to clean an epitaxial wafer before measuring its resistance value. Common cleaning process comprises the steps of: washing, spin-drying, and measuring the resistance value. In the washing step, the epitaxial wafer is washed with HF at a concentration between 25% and 40%; it is rinsed with pure water; then the epitaxial wafer is processed with H₂O₂ (at a concentration between 15% and 30%) /NH₄OH (at a concentration between 15% and 30%); it is rinsed with pure water; and finally, it is process with a developing solution. After all those treatments are completed, measuring the resistance value of the epitaxial wafer using a measuring device. However, such a method has a big problem, that is, pre-treatment may affect the uniformity of the resistance value, to be specific, the resistance value may fluctuate in a range from 2% to 10% (calculation formula: (max-min)/(max+min)-1)*100%. While in the semiconductor industry, it is required that the uniformity of the resistance value is less than 3%. Therefore, the existing method for processing an epitaxial wafer before measuring its resistance value is not stable as expected.

### SUMMARY OF THE INVENTION

A main object of the invention is to overcome disadvantages in the prior art, and provides a stable method for processing an epitaxial wafer before measuring its resistance value.

In order to achieve the above-mentioned object, the invention is implemented by using the following technical solution.

A method for processing an epitaxial wafer before measuring its resistance value, comprising the steps of:
(1) washing; (2) spin-drying; (3) heating and drying; (4) eliminating static electricity on the wafer.

According to an embodiment of the present invention, Step (2) can be performed simultaneously with Step (3), in which heating and drying are carried out with spin-drying while eliminating static electricity.

According to an embodiment of the present invention, the heating and drying are performed with nitrogen.

According to an embodiment of the present invention, the heating and drying are carried out at a temperature between 40 °C and 60 °C for 100-300 seconds.

According to an embodiment of the present invention, in Step (4), an N-type epitaxial wafer is processed for 400-800 seconds; and a P-type epitaxial wafer is processed for 800-1500 seconds.

According to an embodiment of the present invention, when the epitaxial wafer is an N-type epitaxial wafer, Step (1) comprises the steps of:
washing the N-type epitaxial wafer at room temperature for 80-100 seconds with HF at a concentration between 25% and 40%; washing the N-type epitaxial wafer at room temperature for 60-200 seconds with pure water in an overflow groove, then washing the N-type epitaxial wafer at a temperature between 70 °C and 80 °C for 400-700 seconds with hydrogen peroxide at a concentration of 31%; then washing the N-type epitaxial wafer at a temperature for 60-200 seconds with pure water in the overflow groove.

According to an embodiment of the present invention, when the N-type epitaxial wafer has a resistivity of less than 1.5 ohm-cm, Step (1) further comprises processing the N-type epitaxial wafer using a developing solution for 90-200 seconds.

According to an embodiment of the present invention, when the epitaxial wafer is a P-type epitaxial wafer, Step (1) comprises the steps of:
washing the P-type epitaxial wafer at room temperature for 80-100 seconds with HF at a concentration between 25% and 40%; then washing the P-type epitaxial wafer at room temperature for 60-200 seconds with pure water in the overflow groove.

According to an embodiment of the present invention, when the epitaxial wafer is washed with clean water in the overflow groove, the clean water in the overflow groove is drained every 20-40 seconds.

According to an embodiment of the present invention, the clean water in the overflow groove is drained within 5-15 seconds.

In the method for processing an epitaxial wafer before measuring its resistance value as disclosed in the present invention, the overflow groove process is changed to an overflow + quick discharge process, so as to ensure that the acid and alkali residues on a surface of the wafer are washed out, so as not to affect the measurement effect. Static electricity elimination treatment is used to eliminate static electricity and dangling bonds on the surface of the wafer, so that measurements of the resistance value may not be affected, to a large extent. The resistance uniformity of the epitaxial wafer processed by the method for processing an epitaxial wafer before measuring its resistance value is less than 1.5%, which fully meets the requirements when compared to the industry requirement of less than 3%.

### DETAILED DESCRIPTION

The present invention will now be described more fully hereinafter with reference to the accompanying drawings, in which exemplary embodiments of the invention are shown.

A method for processing an epitaxial wafer before measuring its resistance value, comprising the steps of:
(1) washing; (2) spin-drying; (3) heating and drying; (4) eliminating static electricity on the wafer.

According to an embodiment of the present invention, when the epitaxial wafer is an N-type epitaxial wafer, Step (1) comprises the following steps of:
washing the N-type epitaxial wafer at room temperature for 80-100 seconds with HF at a concentration between 25% and 40%; washing the N-type epitaxial wafer at room temperature for 60-200 seconds with pure water in an overflow groove, then washing the N-type epitaxial wafer at a temperature between 70 °C and 80 °C for 400-700 seconds with hydrogen peroxide at a concentration of 31%; then washing the N-type epitaxial wafer at room temperature for 60-200 seconds with pure water in the overflow groove.

When the N-type epitaxial wafer has a resistivity of less than 1.5 ohm-cm, Step (1) further comprises processing the N-type epitaxial wafer using a developing solution for 90-200 seconds.

According to an embodiment of the present invention, Step (2) can be performed simultaneously with Step (3), in which heating and drying are carried out with spin-drying while eliminating static electricity.

The heating and drying are performed with nitrogen. The heating and drying are carried out at a temperature between 40 °C and 60 °C for 100-300 seconds.

In Step (4), an N-type epitaxial wafer is processed for 400-800 seconds; and a P-type epitaxial wafer is processed for 800-1500 seconds.

According to an embodiment of the present invention, when the epitaxial wafer is a P-type epitaxial wafer, Step (1) comprises the steps of:
washing the P-type epitaxial wafer at room temperature for 80-100 seconds with HF at a concentration between 25% and 40%; then washing the P-type epitaxial wafer at room temperature for 60-200 seconds with pure water in the overflow groove.

According to an embodiment of the present invention, when the epitaxial wafer is washed with clean water in the overflow groove, the clean water in the overflow groove is drained every 20-40 seconds.

According to an embodiment of the present invention, the clean water in the overflow groove is drained within 5-15 seconds.

| Embodime nt | Type of epitaxial wafer | HF concentratio n and washing time | washing time for clean water in an overflow groove | Clean water drain frequency and drain time | Time and temperature for washing with H₂O2 | Time for washing clean water in overflow groove | Clean water drain frequency and drain time | Treatme nt using a developi ng solution | drying temper ature and time | Static electricity elimination time |
|---|---|---|---|---|---|---|---|---|---|---|
| 1 | N-type Resistivi ty <1. 5ohm-c m | 25%, 80s | 60s | It is drained every 30 seconds; 5s | 70°C; 400s | 70s | It is drained every 25 seconds;; 10s | 90s | 40 °C ; 100s | 400s |
| 2 | N-type Resistivi ty <1. 5ohm-c m | 32%, 86s | 70s | It is drained every 28 seconds;8s | 73°C; 660s | 110s | It is drained every 30 seconds;; 8s | 200 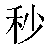 | 55 °C; 150s | 500s |
| 3 | N-type Resistivi ty >1.5 ohm | 28%, 90s | 90s | It is drained every 33 seconds;; 10s | 78°C; 450s | 60 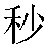 | It is drained every 35 seconds;; 15s | N/A | 60 °C; 120s | 600s |
| 4 | N-type Resistivi ty >1.5 ohm | 40%, 100s | 145s | It is drained every 22 seconds;; 6s | 75°C; 600s | 180s | It is drained every 20 seconds;; 6s | 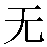 | 50 °C; 260s | 800s |
| 5 | P-type | 37%, 95s | 200s | It is drained every 35 seconds;; 15s | N/A | N/A | N/A | N/A | 45 °C; 220s | 1500s |
| 6 | P-type | 29%, 98s | 180s | It is drained every 30 seconds;; 7s | N/A | N/A | N/A | N/A | 60 °C; 160s | 1100s |
| 7 | P-type | 34%, 80s | 100s | It is drained every 28 seconds;; 12s | N/A | N/A | N/A | N/A | 52°C; 260s | 800s |
| 8 | P-type | 35%, 90 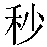 | 150s | It is drained every 28 seconds;; 15s | N/A | N/A | N/A | N/A | 50 °C; 200s | 900s |

After detection, the resistivity of the epitaxial wafer detected by the method disclosed in the present invention is as follows:

| Wafer Type | Resistance value (ohm-cm) | Industry standards for resistance uniformity | Resistance uniformity for old process | Resistance uniformity for new process |
|---|---|---|---|---|
| N | 0.8 | <3% | 2-7% | 1.2-1.8% |
| N | 1.5 | <3% | 2-5.7% | 1.4-2.1% |
| N | 3 | <3% | 2-9.5% | 1.3-1.9% |
| N | 5 | <3% | 2-5% | 0.8-2% |
| N | 10 | <3% | 2-4% | 0.5-1.2% |
| N | 20 | <3% | 2-4.5% | 1-1.8% |
| N | 40 | <3% | 2-4.9% | 1-1.7% |
| N | 60 | <3% | 2-6.5% | 1-1.75% |
| N | 80 | <3% | 2-5.7% | 0.5-1.1% |
| N | 100 | <3% | 3-7% | 0.3-1.7% |
| P | 3 | <3% | 2-10% | 0.9-2.6% |
| P | 4.5 | <3% | 2-8% | 0.3-1.9% |
| P | 11.7 | <3% | 2-7.5% | 0.5-2.1% |
| P | 30 | <3% | 2-9.4% | 1-2.4% |
| P | 69 | <3% | 2-6% | 0.4-2.2% |

In the method for processing an epitaxial wafer before measuring its resistance value as disclosed in the present invention, the overflow groove process is changed to an overflow + quick discharge process, so as to ensure that the acid and alkali residues on a surface of the wafer are washed out, so as not to affect the measurement effect. Static electricity elimination treatment is used to eliminate static electricity and dangling bonds on the surface of the wafer, so that measurements of the resistance value may not be affected, to a large extent. The resistance uniformity of the epitaxial wafer processed by the method for processing an epitaxial wafer before measuring its resistance value is less than 1.5%, which fully meets the requirements when compared to the industry requirement of less than 3%.

The above descriptions are only the preferred embodiments of the invention, not thus limiting the embodiments and scope of the invention. Those skilled in the art should be able to realize that the schemes obtained from the content of specification and drawings of the invention are within the scope of the invention.

## Claims

1. A method for processing an epitaxial wafer before measuring its resistance value, comprising the steps of:
(1) washing; (2) spin-drying; (3) heating and drying; (4) eliminating static electricity on the wafer.

2. The method for processing an epitaxial wafer before measuring its resistance value of claim 1, wherein Step (2) can be performed simultaneously with Step (3), in which heating and drying are carried out with spin-drying while eliminating static electricity.

3. The method for processing an epitaxial wafer before measuring its resistance value of claim 1 or 2, wherein the heating and drying are performed with nitrogen.

4. The method for processing an epitaxial wafer before measuring its resistance value of claim 1 or 2, wherein the heating and drying are carried out at a temperature between 40 °C and 60 °C for 100-300 seconds.

5. The method for processing an epitaxial wafer before measuring its resistance value of claim 1, wherein in Step (4), an N-type epitaxial wafer is processed for 400-800 seconds; and a P-type epitaxial wafer is processed for 800-1500 seconds.

6. The method for processing an epitaxial wafer before measuring its resistance value of claim 1, wherein when the epitaxial wafer is an N-type epitaxial wafer, Step (1) comprises the steps of:
washing the N-type epitaxial wafer at room temperature for 80-100 seconds with HF at a concentration between 25% and 40%; washing the N-type epitaxial wafer at room temperature for 60-200 seconds with pure water in an overflow groove, then washing the N-type epitaxial wafer at a temperature between 70 °C and 80 °C for 400-700 seconds with hydrogen peroxide at a concentration of 31%; then washing the N-type epitaxial wafer at room temperature for 60-200 seconds with pure water in the overflow groove.

7. The method for processing an epitaxial wafer before measuring its resistance value of claim 6, wherein when the N-type epitaxial wafer has a resistivity of less than 1.5 ohm-cm, Step (1) further comprises processing the N-type epitaxial wafer using a developing solution for 90-200 seconds.

8. The method for processing an epitaxial wafer before measuring its resistance value of claim 1, wherein when the epitaxial wafer is a P-type epitaxial wafer, Step (1) comprises the steps of:
washing the P-type epitaxial wafer at room temperature for 80-100 seconds with HF at a concentration between 25% and 40%; then washing the P-type epitaxial wafer at room temperature for 60-200 seconds with pure water in the overflow groove.

9. The method for processing an epitaxial wafer before measuring its resistance value of claim 6 or 8, wherein when the epitaxial wafer is washed with clean water in the overflow groove, the clean water in the overflow groove is drained every 20-40 seconds.

10. The method for processing an epitaxial wafer before measuring its resistance value of claim 9, wherein the clean water in the overflow groove is drained within 5-15 seconds.
